Europäisches Patentamt

European Patent Office

Office européen des brevets

(11) Numéro de publication: **0 218 526**
**A1**

(12) **DEMANDE DE BREVET EUROPEEN**

(21) Numéro de dépôt: **86402126.6**

(22) Date de dépôt: **29.09.86**

(51) Int. Cl.⁴: **H 01 L 23/42**

(30) Priorité: **30.09.85 FR 8514419**

(43) Date de publication de la demande:
**15.04.87 Bulletin 87/16**

(84) Etats contractants désignés:
**BE CH DE FR GB IT LI**

(71) Demandeur: **JEUMONT-SCHNEIDER Société anonyme dite:**
**31-32, Quai de Dion Bouton**
**F-92811 Puteaux Cedex (FR)**

(72) Inventeur: **Chauvet, Claude**
**15, Allée Jean Paulhan**
**F-93270 Sevran (FR)**

(74) Mandataire: **Lejet, Christian**
**Société JEUMONT-SCHNEIDER 31-32, Quai de Dion Bouton**
**F-92811 Puteaux Cedex (FR)**

(54) Installation de dissipation pour éléments semi-conducteurs de puissance.

(57) La présente invention concerne une installation de dissipation pour éléments semi-conducteurs de puissance qui comprend, en combinaison, une colonne comportant, de façon alternée, des éléments semi-conducteurs de puissance (10) est des caissons d'évaporation (16) en un matériau bon conducteur de la chaleur, les éléments semi-conducteurs et des caissons d'évaporation étant en contact thermique et électrique, les caissons étant pourvus de moyens de raccordement électrique; des moyens d'échange de chaleur (20) à ailettes de refroidissement (34) respectivement associés à chaque caisson d'évaporation; deux moyens de raccordement de fluide s'étendant entre chaque caisson d'évaporation et les moyens d'échange de chaleur, et comportant chacun une partie électriquement isolante (26; 40) et une partie métallique souple (24; 42). Un fluide caloporteur diélectrique assure la dissipation de la chaleur engendrée par les éléments semi-conducteurs en s'évaporant dans chaque caisson d'évaporation, en se dirigeant vers les moyens d'échange de chaleur par le premier moyen de raccordement, en se condensant dans lesdits moyens d'échange de chaleur et en retournant dans ledit caisson par le second moyen de raccordement.

FIG.1

EP 0 218 526 A1

## Description

Installation de dissipation pour éléments semi-conducteurs de puissance

La présente invention a trait d'une façon générale à la dissipation de la chaleur engendrée par des éléments semi-conducteurs de puissance, et vise plus particulièrement une installation de dissipation dans laquelle on réalise un isolement galvanique des éléments semi-conducteurs par rapport aux éléments dissipateurs.

Il est bien connu de presser des éléments semi-conducteurs entre deux éléments radiateurs. Les radiateurs peuvent être refroidis par air, en étant directement ventilés en convection naturelle ou forcée. Ils peuvent également être refroidis par un système de circulation de liquide de refroidissement. La première solution est désavantageuse en ce que les radiateurs qui sont sous tension s'encrassent très rapidement, d'où la nécessité de filtrer l'air. La solution du refroidissement par liquide implique quant à elle une pompe, des vannes et des organes de contrôle.

On connaît en outre, notamment par le brevet Allemand DE-OS-24 14270 un dispositif de réfrigération par évaporation pour éléments semi-conducteurs, selon lequel des éléments semi-conducteurs sont empilés alternativement avec des boîtes de réfrigération dans lesquelles circule un liquide réfrigérant électriquement isolant. Les boîtes de réfrigération sont en circuit fermé avec des éléments dissipateurs. Dans ce genre de dispositif, une partie du circuit de refroidissement est au potentiel du ou des semi-conducteurs associés, ce qui est désavantageux. En outre, la détaillance d'un élément semi-conducteur nécessite un démontage particulièrement complexe du circuit de refroidissement pour le remplacement dudit semi-conducteur. Enfin, ce type de dispositif ne permet pas de disposer les semi-conducteurs dans une enceinte étanche en laissant les éléments dissipateurs à l'air libre.

Enfin, le brevet Français No. 2 544 918 enseigne un dispositif de refroidissement dans lequel les collecteurs de vapeur et de liquide sont isolants, et l'élément de réfrigération est isolé galvaniquement des semi-conducteurs. Cependant, dans ce dispositif, la tuyauterie flexible de raccordement et la visserie de montage sont électriquement conducteurs, et sous tension, ce qui est encore une fois désavantageux.

La présente invention vise à pallier ces inconvénients et à proposer une installation de dissipation de chaleur pour éléments semi-conducteurs, du type à évaporation/condensation de liquide caloporteur, dans lequel les éléments dissipateurs tout entiers soient galvaniquement isolés des éléments semi-conducteurs.

Un autre objet de la présente invention est de proposer une telle installation de dissipation dans laquelle il soit possible de placer les éléments semi-conducteurs dans une enceinte étanche aux poussières, qui ne comporte aucun organe mécanique en mouvement, et dont l'entretien soit aisé et rapide.

A cet effet, la présente invention concerne une installation de dissipation pour éléments semi-conducteurs de puissance, caractérisée en ce qu'elle comprend, en combinaison:

une colonne comportant, de façon alternée, des éléments semi-conducteurs de puissance et des caissons d'évaporation en un matériau bon conducteur de la chaleur, au moins certains des éléments semi-conducteurs et des caissons d'évaporation étant en contact thermique et électrique, les caissons étant par ailleurs pourvus de moyens de raccordement électrique,

des moyens d'échange de chaleur respectivement associés à chaque caisson d'évaporation, comportant des ailettes de refroidissement,

deux moyens de raccordement de fluide s'étendant entre chaque caisson d'évaporation et les moyens d'échange de chaleur, et comportant chacun une partie électriquement isolante et une partie métallique souple, et

un fluide caloporteur diélectrique assurant la dissipation de la chaleur engendrée par les éléments semi-conducteurs en s'évaporant dans chaque caisson d'évaporation, en se dirigeant vers les moyens d'échange de chaleur par le premier moyen de raccordement, en se condensant dans lesdits moyens d'échange de chaleur et en retournant dans ledit caisson par le second moyen de raccordement.

L'invention sera mieux comprise à la lecture de la description détaillée suivante d'un mode de réalisation préféré de celle-ci, donnée à titre d'exemple et faite en référence au dessin annexé, sur lequel:

la figure 1 est une vue de côté en coupe partielle d'une installation de dissipation selon l'invention, et

la figure 2 est une vue de face de l'installation de la figure 1.

En référence aux figures, on trouve tout d'abord un circuit électrique de type conventionnel comprenant des composants actifs, à savoir des éléments semi-conducteurs de puissance 10, montés dans des boîtiers dits "power disk", et des composants passifs, dans le cas présent des condensateurs 12 et des résistances de protection 14. D'une manière bien connue dans le domaine de l'électronique de puissance, les éléments semi-conducteurs dissipent une certaine chaleur qu'il est nécessaire d'évacuer par un système de refroidissement, afin que leur température demeure suffisamment basse pour ne pas les endommager ou altérer leur fiabilité. A cet égard, les éléments semi-conducteurs 10 sont montés en sandwich et pressés entre une pluralité de premiers caissons d'évaporation 16 s'étendant parallèlement les uns aux autres et sensiblement verticalement. Les caissons 16 sont réalisés en un métal de conductibilité thermique et électrique élevée, tel que le cuivre, et comportent une ou plusieurs cavités intérieures communiquant entre elles et destinés à la circulation d'un fluide caloporteur, comme décrit plus loin. Un film de graisse thermique est disposé sur les électrodes de chaque élément semi-conducteur 10 en contact avec les caissons d'évaporation 16, afin de favoriser l'échange thermique avec ceux-ci. De plus, les composants passifs 12, 14 sont montés sur la surface extérieure de seconds caissons d'évaporation 18, également en cuivre.

L'installation de dissipation selon l'invention comprend, outre les caissons d'évaporation 16 et 18, des unités d'échange de chaleur, globalement indiquées en 20 et 22, et respectivement associées auxdits caissons, comme décrit en détail plus loin.

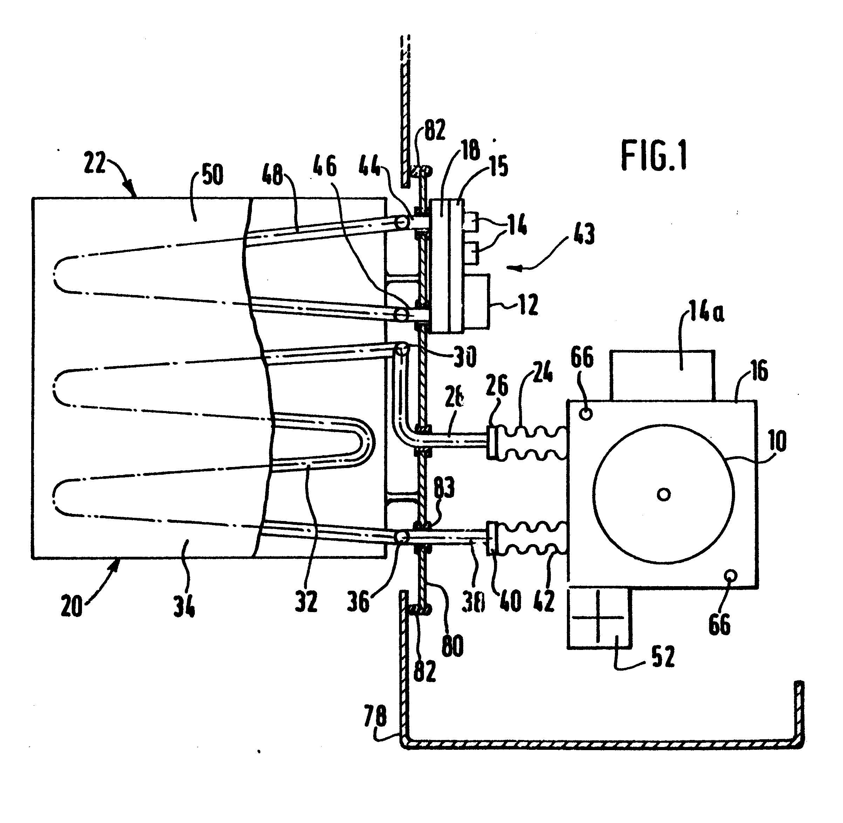

Comme le montre mieux la figure 1, chaque caisson d'évaporation 16 est raccordé à l'unité d'échange de chaleur (élément de dissipation) associée 20 par un conduit souple 24 de sortie de vapeur, de préférence en acier inoxydable ondulé, suivi d'un élément de raccord 26 électriquement isolant, par exemple en verre ou en céramique, et d'un tube coudé 28, en un métal conducteur tel que le cuivre. On réalise ainsi l'isolation des ensembles semi-conducteurs/caissons d'évaporation par rapport aux unités de dissipation 20. Le tube 28 débouche au collecteur de vapeur 30 de l'unité 20.

L'unité 20 comporte une pluralité de tubes d'échange de chaleur en serpentin 32, de préférence en cuivre, sur lesquels sont fixées, par exemple par brasage, des ailettes 34 en métal conducteur de la chaleur approprié, tel que du cuivre ou de l'aluminium. De façon conventionnelle, on pourra peindre l'ensemble en noir de manière à augmenter l'émissivité des surfaces de refroidissement, en particulier dans le cas où l'installation opère en ventilation naturelle. On disposera alors les ailettes verticalement. Un collecteur de condensat 36 communique avec les extrémités inférieures des tubes 32. De la même manière qu'on l'a décrit plus haut, le collecteur de condensat 36 est relié à l'entrée de liquide du caisson d'évaporation 16 par l'intermédiaire d'un tube de cuivre 38, d'un élément de raccord isolant 40 en verre ou en céramique, et d'un conduit souple d'entrée de liquide 42, en acier inoxydable ondulé.

Un liquide caloporteur conventionnel, tel qu'un hydrocarbure fluoré, est mis en place dans le circuit fermé décrit ci-dessus.

Par ailleurs, chaque caisson d'évaporation 18 reçoit les composants passifs 12, 14 du circuit électronique de puissance par l'intermédiaire d'une plaque métallique 15, de préférence en cuivre. On réalise ainsi une structure de composants passifs modulaire, chaque module, globalement indiqué en 43, étant associé à un ou plusieurs des éléments semi-conducteurs 10. Chaque caisson 18 d'un module de composants passifs 12, 14 est raccordé à une seconde unité d'échange de chaleur (dissipateur) associée 22 par l'intermédiaire de tubes métalliques 44, 46, par exemple en cuivre, respectivement pour la sortie de vapeur et l'entrée de liquide. L'unité 22 comporte une pluralité de conduits en serpentin 48 sur lesquels sont fixées des ailettes 50 en métal conducteur de la chaleur.

La structure (matériaux choisis, mode d'assemblage) de l'unité 22 sera de préférence sensiblement identique à celle de l'unité 20.

Les corps de dissipateurs (ailettes) 34 et 50 pourront être indépendants ou unitaires, selon les cas. Il est cependant préférable que le corps de dissipateur 34 soit situé au dessous du corps de dissipateur 50, afin que l'air le plus froid bénéficie en premier au refroidissement des éléments semi-conducteurs 10. En effet, les résistances 14 supportent généralement des températures supérieures à celle des semi-conducteurs 10, les condensateurs 12, qui sont froids, restant conventionnellement montés à proximité desdites résistances. Le corps de dissipateur 50 est donc à une température plus élevée que le corps de dissipateur 34, ce qui favorise les courants d'air ascentionnels de la convection naturelle.

On peut noter ici que les conduits souples 24,42 en acier inoxydable ondulé ont pour objet de limiter les sollicitations exercées sur les fixations des diverses tuyauteries (brasures, scellements, etc...), à des fins de fiabilité, notamment lorsque, pour mettre en place où remplacer un élément semi-conducteur 10, on est amené à déplacer les caissons d'évaporation 16 ou à leur appliquer la force de serrage nécessaire à une transmission de chaleur satisfaisante de la part des éléments semi-conducteurs, comme décrit plus loin.

Selon une variante de l'invention, et lorsque la configuration le permet, on pourra monter certains composants passifs du circuit électronique de puissance, tels que des résistances d'équilibrage dynamique, indiquées en 14a, sur les caissons d'évaporation 16 des éléments semi-conducteurs 10.

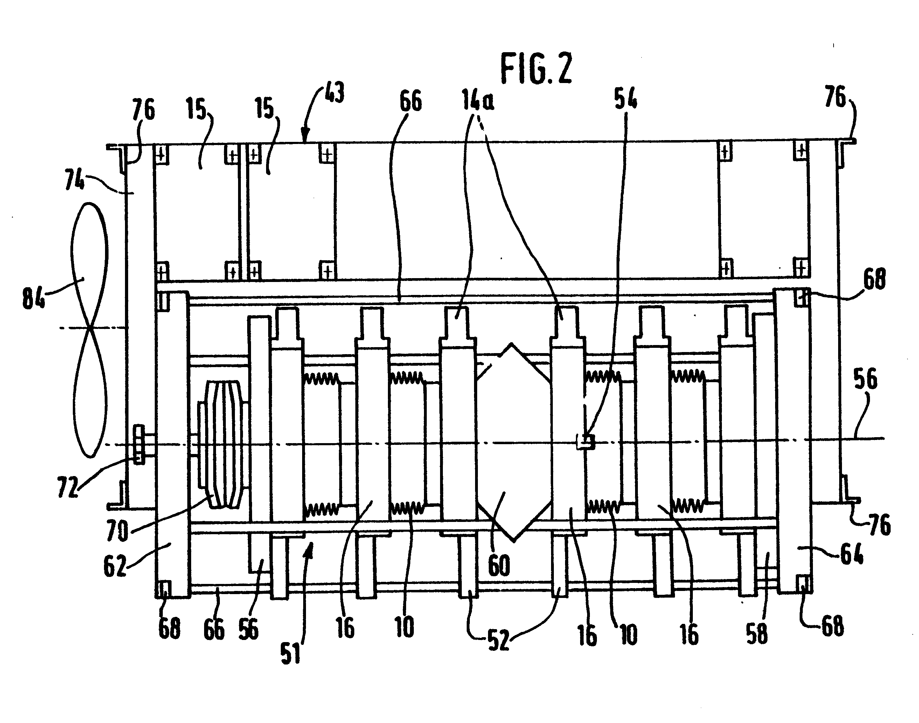

Sur la figure 2 est mieux représenté l'assemblage des divers éléments de l'installation.

En référence à cette figure, les éléments semi-conducteurs 10 et les caissons d'évaporation 16 associés sont empilés de manière à former une colonne, globalement indiquée en 51, les caisses d'évaporation tenant lieu également de connexions électriques et comportant des bornes de raccordement telles qu'indiquées en 52. Les semi-conducteurs 10 et les caissons d'évaporation 16 sont centrés les uns par rapport aux autres au moyen de pions de centrage 54 disposés axialement dans des orifices (non référencés) prévus à cet effet dans chacune des surfaces en regard, afin d'assurer leur alignment correct sur l'axe 56 de la colonne. Un tel centrage est nécessaire pour pouvoir exercer dans de bonnes conditions l'effort de serrage des éléments entre eux, comme décrit plus loin et dans le but d'assurer une bon transfert thermique entre les éléments semi-conducteurs 10 et les caissons d'évaporation 16.

Aux deux extrémités de la colonne sont respectivement prévus deux éléments isolants 57,58 destinés à l'isolation électrique de l'ensemble de celle-ci.

Par ailleurs, on peut utiliser dans la colonne un ou plusieurs éléments isolants intermédiaires (dont un est indiqué en 60), destinés à isoler électriquement deux éléments semi-conducteurs adjacents lorsque cela est imposé par le plan de câblage. Dans le cas où la chaleur dégagée par les semi-conducteurs à isoler l'exige, on pourra en outre interposer entre lesdits semi-conducteurs 10 et l'isolant intermédiaire 60 des caissons d'évaporation 16 du type décrit plus haut.

La colonne 51 vient se loger entre deux plateaux d'extrémité 62, 64 entretoisés par des tiges filetées 66 elles-mêmes bloquées par des écrous 68. Le cas échéant, on pourra munir les tiges 66 d'un gainage isolant (non représenté). Le serrage de la colonne 51 est effectué par rapport au plateau 62 par l'intermédiaire d'un élément de serrage conventionnel 70 associé à une vis 72.

L'ensemble de l'installation est monté sur un bâti 74 et est fixé, par exemple à l'aide de cornières 76, à l'intérieur d'un coffre (non représenté). Afin d'éviter que la colonne 51 soit en porte-à-faux, on pourra fixer les plateaux 62, 64 sur ledit coffre à l'aide d'équerres de montage appropriées. Sur la figure 1 est indiquée en 78 la partie du coffre sur laquelle a lieu cette fixation. Cette partie 78 pourra être conçue pour pouvoir être démontée solidairement avec l'ensemble de l'installation, afin de permettre la dépose de celle-ci vers le bas. Cette solution sera particulièrement intéressante dans le cas où l'installation sera montée à bord d'une motrice de métropolitain.

Par ailleurs, et toujours en référence à la figure 1, on pourra prévoir une cloison étanche 80 entre la partie composants (à droite de la cloison en observant la figure 1) et la partie dissipateurs (à gauche). L'étanchéité sera obtenue à l'aide de joints appropriés 82, des presse-étoupes 83 étant par ailleurs prévus dans la plaque 80 pour le passage des diverses tuyauteries métalliques. Un tel aménagement permet de disposer l'ensemble des composants dans une région étanche du coffre.

Enfin on pourra équiper l'installation de dissipation de l'invention d'un ou plusieurs ventilateurs, comme indiqué en 84, afin d'obtenir une dissipation satisfaisante dans un volume réduit. Le ou les ventilateurs pourront être équipés d'un dispositif de commande thermostatique.

Le fonctionnement de l'installation telle que décrite ci-dessus est le suivant: Chaque semi-conducteur 10 enserré entre deux caissons d'évaporation 16 et en contact thermique et électrique avec eux peut ainsi transmettre auxdits caissons la chaleur qu'il dégage pendant son fonctionnement. Cet apport de chaleur provoque l'ébullition du liquide caloporteur, et la vapeur ainsi formée dans un caisson est évacuée vers l'unité d'échange de chaleur 20, dans laquelle elle se condense. Le condensat descend alors par gravité dans les tubes d'échange de chaleur 32 jusqu'à atteindre la surface libre (non représentée) du fluide caloporteur à l'état liquide. Ce liquide peut retourner vers la région inférieure du caisson par les passages 38, 40, 42 mentionnés plus haut, où il s'évaporera à nouveau. On réalise ainsi un circuit fermé à circulation spontanée pour un refroidissement simple et efficace des éléments semi-conducteurs. Les éléments dissipateurs sont électriquement isolés des semi-conducteurs, ce qui est avantageux tant sur le plan de la sécurité que de l'encrassement. Cela permet notamment de relier les dissipateurs à la masse de l'installation, et/ou de pouvoir les exposer aux intempéries. Par ailleurs, le remplacement d'un ou plusieurs semi-conducteurs dans la colonne 51 peut être réalisé facilement, sans risquer de rompre les diverses connexions (brasures, ...) des tuyauteries.

Enfin, la structure de l'installation de refroidissement selon l'invention permet de disposer les composants électroniques dans une enceinte étanche à l'air, les dissipateurs associés restant à l'air libre. On isole ainsi toutes les pièces sous tension.

Bien entendu, la présente invention n'est pas limitée au mode de réalisation décrit, mais inclut dans sa portée toute modification ou variante que pourra y apporter l'homme de l'art. Ainsi, dans le cas où le circuit de puissance à semi-conducteurs est utilisé dans des engins de traction ferroviaire, on pourra profiter du mouvement de l'engin pour améliorer la convection de l'air sur le ou les éléments dissipateurs, en pratiquant dans l'installation des ouies d'entrée et de sortie d'air appropriées et en orientant convenablement les ailettes de refroidissement.

Par ailleurs, on pourra utiliser pour réaliser les éléments de l'installation de dissipation tout métal ou alliage métallique ayant un comportement mécanique, électrique et thermique approprié.

Enfin, dans le cas où l'installation est embarquée à bord d'un véhicule tel qu'un engin de traction ferroviaire, on prévoira dans le ou les circuits d'échange de chaleur une quantité de fluide caloporteur suffisante pour que, lorsque l'installation se trouve en dévers ou en pente, et/ou est soumis à une accélération ou à une décélération, l'alimentation des caissons d'évaporation en condensat ait toujours lieu.

**Revendications**

1. Installation de dissipation pour éléments semi-conducteurs de puissance, caractérisée en ce qu'elle comprend, en combinaison:
une colonne comportant, de façon alternée, des éléments semi-conducteurs de puissance (10) et des caissons d'évaporation (16) en un matériau bon conducteur de la chaleur, au moins certains des éléments semi-conducteurs et des caissons d'évaporation étant en contact thermique et électrique, les caissons étant par ailleurs pourvus de moyens de raccordement électrique,
des moyens d'échange de chaleur (20) respectivement associés à chaque caisson d'évaporation, comportant des ailettes de refroidissement (34),
deux moyens de raccordement de fluide s'étendant entre chaque caisson d'évaporation et les moyens d'échange de chaleur, et comportant chacun une partie électriquement isolante (26; 42) et une partie métallique souple (24; 42), et un fluide caloporteur diélectrique assurant la dissipation de la chaleur engendrée par les éléments semi-conducteurs en s'évaporant dans chaque caisson d'évaporation, en se dirigeant vers les moyens d'échange de chaleur par le premier moyen de raccordement, en se condensant dans lesdits moyens d'échange et en retournant dans ledit caisson par le second moyen de raccordement.

2. Installation selon la revendication 1. caractérisée en ce que chaque caisson d'évaporation (16) comporte dans sa region inférieure un orifice d'entrée de fluide caloporteur à l'état liquide, et dans sa région supérieure un orifice de sortie de fluide caloporteur à l'état vaporisé.

3. Installation selon l'une quelconque des revendications 1 et 2, caractérisée en ce que les moyens d'échange de chaleur comprennent au moins un tube en serpentin (32) sur lequel sont fixées des ailettes de refroidissement (34).

4. Installation selon l'une quelconque des revendications 1 à 3, caractérisée en ce que les parties électriquement isolantes (26) des moyens de raccordement comprennent des éléments de raccord en un matériau choisi dans le groupe comprenant le verre et la céramique.

5. Installation selon l'une quelconque des revendications 1 à 4, caractérisée en ce que les parties métalliques souples (24) des moyens de raccordement comprennent des conduits en acier inoxydable ondulé.

FIG.1

0218526

# FIG.2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | DE-A-2 417 106 (SIEMENS)<br>* Figures 1,4; revendications 1-3,5,6 * | 1 | H 01 L 23/42 |
| | --- | | |
| A | US-A-3 989 099 (MITSUBISHI)<br>* Figure 1; revendication 1 * | 1 | |
| | ----- | | |

|  | DOMAINES TECHNIQUES RECHERCHES (Int. Cl.4) |
|---|---|
|  | H 01 L |

Le présent rapport de recherche a été établi pour toutes les revendications

| Lieu de la recherche | Date d'achèvement de la recherche | Examinateur |
|---|---|---|
| LA HAYE | 16-12-1986 | DE RAEVE R.A.L. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

OEB Form 1503 03 82